(19) Europäisches Patentamt

European Patent Office

Office européen des brevets

(11) **EP 0 810 628 A2**

(12) **EUROPÄISCHE PATENTANMELDUNG**

(43) Veröffentlichungstag:
   **03.12.1997   Patentblatt 1997/49**

(51) Int Cl.⁶: **H01J 33/00**, H01J 3/02,
   H01J 3/04, H01J 27/08,
   H01J 29/48, H01J 37/077,
   H01J 37/317, H01J 1/00

(21) Anmeldenummer: **97105519.9**

(22) Anmeldetag: **03.04.1997**

(84) Benannte Vertragsstaaten:
   **CH DE FR GB LI**

(30) Priorität: **31.05.1996   DE 19621874**

(71) Anmelder: **Forschungszentrum Karlsruhe GmbH**
   **76133 Karlsruhe (DE)**

(72) Erfinder:
   • **Engelko, Vladimir, Dr.**
     **195112 St. Petersburg (RU)**

   • **Giese, Harald**
     **76297 Stutensee (DE)**
   • **Müller, Georg**
     **76139 Karlsruhe (DE)**
   • **Schalk, Sven**
     **76135 Karlsruhe (DE)**
   • **Schultheiss, Christoph, Dr.**
     **76347 Berghausen (DE)**
   • **Würz, Hermann, Dr.**
     **76467 Bietigheim (DE)**

(54) **Quelle zur Erzeugung von grossflächigen, gepulsten Ionen- und Elektronenstrahlen**

(57)   Die Erfindung betrifft eine Quelle zur Erzeugung von gepulsten Ionen- und Elektronenstrahlen.

Mit ihr wird ein in seinem Strahlquerschnitt großflächiger Strom geladener Teilchen erzeugt. Die Vakuum-Bogenplasmaquelle wird durch eine den Gesamtstrom bestimmende Last, die aus der Parallelschaltung eines ohmschen Widerstands mit einem Kondensator besteht, zur sichern Zündung geführt. Diese Last ist an den Innenwiderstand des Pulsspannungsgenerators leistungsangepaßt. Die Dimensionierung der elektrischen Bauteile an den Elektroden unter Berücksichtigung vorgegebener Schranken ermöglicht einen in seinem Strahlquerschnitt homogenen Strom geladener Teilchen, der aus ein und demselben Ladungsteilchen bei gleichen Zündelektroden oder aus einem strukturierten Strom unterschiedlicher Teilchensorten bei unterschiedlichem Zündelektrodenmaterial besteht.

**Beschreibung**

Die Erfindung betrifft eine Quelle zur Erzeugung von großflächigen, gepulsten Ionen- und Elektronenstrahlen.

Eine solche gepulste Strahlquelle findet sowohl in der Halbleiterindustrie für die Ionenimplantation als auch in der Metallindustrie im Bereich der Oberflächenbehandlung Anwendung. Darüber hinaus ist die Auswirkung der Bestrahlung von Werkstoffoberflächen mit unterschiedlichen Ionensorten seit Jahren Gegenstand intensiver Untersuchungen in einschlägigen Laboratorien weltweit. Untersuchungen aus diesen Laboratorien führten zu den Ergebnissen, daß durch Wahl geeigneter Ionentypen die Abriebs- und Korrosionsbeständigkeit von Metalloberflächen deutlich verbessert werden können.

Ionenquellen haben im Bereich Halbleiterfertigung weite Verbreitung gefunden, nicht so in andern industriellen Fertigungsbereichen, wo gezielte Fremdmaterialimplantation für die Verbesserung von Materialeigenschaften wichtig ist.

Gegenüber Galvanikbädern für die Oberflächenveredelung z. B. haben Ionenquellen einige gravierende Nachteile, wie:

- Ionenquellen sind zu komplex im Aufbau und der Bedienung,
- Ionenquellen erlauben in den meisten Fällen keine großflächige Materialbehandlung.

Der prinzipielle Aufbau und die Funktionsweise solcher gepulsten Strahlungsquellen wird z. B. in dem Aufsatz "Metal Vapor Vacuum Arc Source" von I. G. Brown et al. in Rev. Sci. Instrum. 57 (6), June 1986 auf den Seiten 1069 bis 1084 beschrieben und erläutert. Diese Gattung von Strahlungsquelle gehört zu der Klasse, die das Plasma, aus dem die gewünschten Ionen extrahiert werden sollen, durch eine Bogenentladung im Vakuum erzeugen.

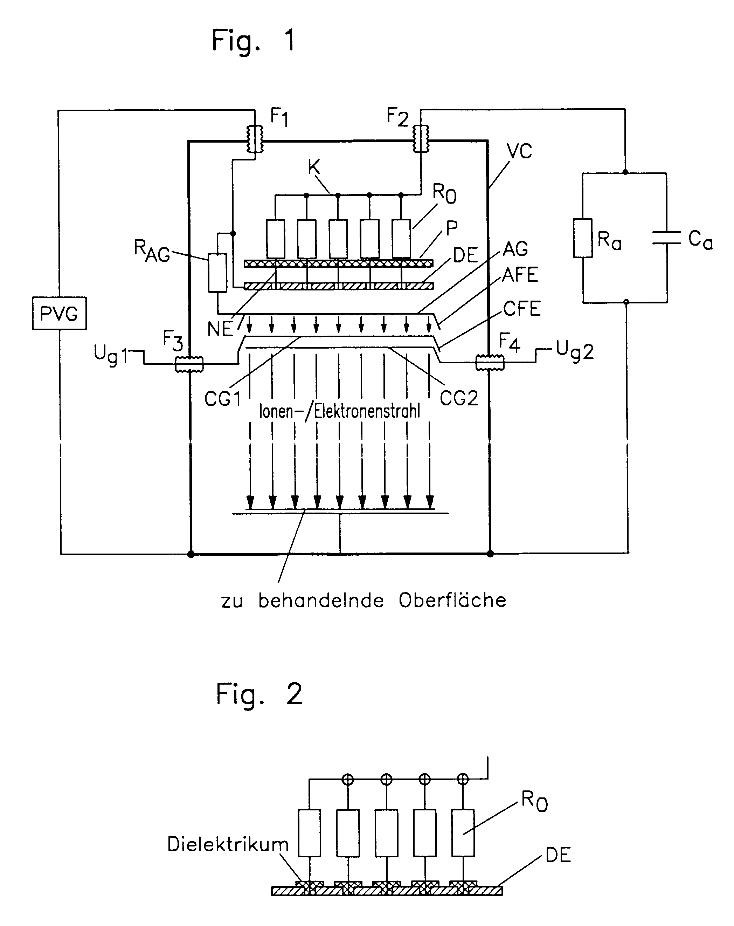

Die Quelle besteht prinzipiell aus drei in einer Vakuum-Kammer untergebrachten Baugruppen (siehe Figur 1 und 4 darin), nämlich einer Vakuum-Bogenplasmaquelle, einem Expansionsraum und einem Extraktionssystem.

Die Bogenplasmaquelle besitzt 3 koaxiale Elektroden: eine Anode, eine Kathode und eine Triggerelektrode. Die Bogenentladung wird durch eine Funkenentladung zwischen der Kathode und der Triggerelektrode gezündet. Der hierzu notwendige Triggerimpuls von einigen Mikrosekunden Länge und einer Spannungsamplitude von 10-20kV wird durch eine Kondensatorentladung produziert, wobei der Kondensator über einen Thyratronschalter und einen Isoliertransformator zwischen Kathode und Triggerelektrode gelegt wird.

Bei der für die Bogenentladung erforderlichen Spannungsquelle handelt sich um eine auf das Niveau der Extraktionsspannung hochgelegte Pulsspannungsquelle (Pulse Forming Line).

Nach dem Zünden der Entladungsstrecke fließt ein Teil der durch die Bogenentladung zwischen Anode und Kathode erzeugten Plasmawolke durch das zentrale Loch in der Anode in Richtung Ionenextraktor.

Das Extraktorsystem besteht aus einer Anordnung von 3 Gittern. Das erste Gitter, d. h. das der Anode am nächsten gelegene, ist mit der Anode über einen Widerstand verbunden, das zweite Gitter erhält eine Vorspannung von -1kV. Das dritte Gitter liegt auf Erdpotential. Die Ionenbeschleunigungsspannung wird zwischen den ersten beiden Gittern angelegt.

Quellen dieser Art besitzen folgende Schwachpunkte:

a) Kleiner Strahldurchmesser von nur wenigen Zentimetern und daher relativ niedriger Ionenstrom.

b) Die Notwendigkeit einer Triggereinheit um die Vakuum-Bogenentladung zu initiieren, bestehend aus Hochspannungsversorgung und Hochspannungstransformator.

c) Die Notwendigkeit einer um die Extraktionsspannung hochliegenden Spannungsversorgung für die Vakuum-Bogenentladung.

d) Die Notwendigkeit einer Synchronisation zwischen der Initiierung der Bogenentladung und dem Anlegen der Extraktionsspannung (solange die Extraktionsspannung noch nicht anliegt, darf das Bogenplasma nicht in den Extraktorbereich vordringen).

e) Der produzierte Ionenstrahl besteht aus nur einer Sorte von Ionen, die durch das Kathodenmaterial der Bogenentladungsstrecke festgelegt ist.

f) Inhomogenität der radialen Stromdichteverteilung (typisch Gauss-Profil), bewirkt durch die radiale Inhomogenität des Plasmas aufgrund von Rekombinationseffekten an den umgebenden Wänden.

Der Strahldurchmesser von Quellen des Brown-Typs kann durch eine matrixartige Anordnung vieler solcher Quellen gesteigert werden. Durch Verwendung unterschiedlicher Kathodenmaterialien in den verschiedenen Quellen würde dies auch die Produktion von Misch-Ionenstrahlen ermöglichen. Jedoch würden nach wie vor die Nachteile b), c), d), f) bestehen bleiben.

Der Erfindung liegt die Aufgabe zugrunde, in Hinblick auf die Oberflächenbearbeitung von Werkstoffen einen möglichst homogenen, großflächigen Strahl elektrisch geladener Teilchen bereitzustellen.

Eine Quelle gemäß dem Oberbegriff des Anspruch 1 ist die Basis zur Lösung der Aufgabe. Die Lösung der Aufgabe wird schließlich durch eine Quelle mit den kennzeichnenden Merkmalen des Anspruch 1 ermöglicht.

Eine Erkenntnis bei der Gestaltung der Anodenanordnung ist, daß der Strahlstrom um 50% bei dem Einbau des Widerstands $R_{AG}$ zwischen dem Anodengitter AG und der Anoden-Entladungselektrode DE erhöht wird. Der Widerstandswert von $R_{AG}$ muß folgende untere Schranke berücksichtigen:

$$R_{AG} \gg T_e / e \, I_{iO} \, (1-\alpha).$$

Dabei ist $T_e$ die Elektronentemperatur im Plasma, e die Elektronenelementarladung und $I_{i0}$ der Ionensättigungsstrom, der sich folgendermaßen berechnet

$$I_{iO} = 0.49 \, e \, n_i \, A \, \sqrt{(T_e/m_i)}$$

mit $n_i$ als Ionenteilchendichte, $m_i$ der Ionenmasse und A der Anodengitterfläche. $\alpha$ ist die Anodengittertransparenz. (Der Faktor 0.49 stammt aus der Plasma-Theorie.) Unter diesen Voraussetzungen kann das Anodengitter AG das "floating potential" des Anodenplasmas annehmen.

Um zu verhindern, daß während der Zündphase ein wesentlicher Teil der Anodenspannung über den Anodenaußenwiderstand $R_A$ abfällt, wird dieser mit dem Kondensator $C_A$ überbrückt. Der Wert des Kondensators wird so gewählt, daß er erst dann vollständig geladen ist, wenn der Zündvorgang abgeschlossen ist. Er liegt zwischen den Schranken

$$T/[(R_A + R_{\|})/R_A R_{\|}] \gg C_A \gg \tau/[(R_A + R_{\|})/R_A R_{\|}].$$

Dabei ist $\tau$ die notwendige Zeitspanne zur Ausbildung der Bogenentladung bzw. der Oberflächenentladung zwischen den Drahtelektroden NE und der Anoden-Entladungselektrode DE. T ist die Dauer des Hochspannungsimpulses. Der gesamte Drahtelektrodenwiderstand ist

$$R_{\|} = R_o/n,$$

wobei n die Gesamtzahl der Drahtelektroden ist.

Der Entladestrom $i_{entl}$ über die parallel liegenden Drahtelektroden NE ist im eingeschwungenen Zustand gleich dem Quotienten $U/R_A$ aus angelegter Hochspannung U und dem Außenwiderstand $R_A$. Viele, im Entladungsfall parallel geschaltete Reihenwiderstände $R_O$ - um über dem Strahlquerschnitt homogene Strahlverhältnisse zu erreichen, benötigt man viele (n) Drahtelektroden NE und damit entsprechend viele Reihenwiderstände $R_0$ - fallen gegenüber $R_A$ nicht ins Gewicht, sie können damit bei der Dimensionierung vernachlässigt werden.

Es ist somit auf einfache Art möglich, über die Wahl von $R_A$ im durchgezündeten bzw. eingeschwungenen Fall den Entladestrom $i_{entl}$ und somit die Produktionsrate des Anodenplasmas und hierdurch den von der Quelle gelieferten, dem Entladestrom $i_{entl}$ proportionalen Ionenstrom $i_i$ zu steuern. Da, wie bei Quellen dieses Typs üblich, der von der Quelle gelieferte Ionenstrom $i_i$ nur etwa 5% des Entladestroms $i_{entl}$ beträgt, bestimmt letzterer im wesentlichen die Gesamtstromaufnahme der Quelle. Dies impliziert, daß $R_A$ die Hauptlast für den die Quelle speisenden Pulsgenerator PVG repräsentiert. Abstimmen des Generatorwiderstands $R_i$ des Pulsgenerators PVG auf den Widerstand $R_A$ erlaubt somit auf einfache Weise eine spannungsunabhängige Leistungsanpassung zwischen Quelle und Energieversorgung.

Damit die Serienwiderstände $R_0$ keine Metalldampfablagerung erfahren und dadurch nach längerem Betrieb über eine metallisierte Oberfläche kurzgeschlossen werden, sind sie vom Raum der Drahtelektroden NE durch eine dielektrische Platte P abgeschottet.

Um einen Strahlquerschnitt mit homogen verteilten Ionen zu erzeugen müssen grundsätzlich viele (n) Drahtelektroden aufgestellt werden. Zur Erzeugung unterschiedlicher Ionen bestehen die Drahtelektroden aus entsprechendem Material. Durch eine entsprechende Anordnung der Drahtelektroden unterschiedlichen Materials läßt sich nun entweder ein Ionenstrom erzeugen, in dem Ionensorten homogen verteilt sind, sofern die Drahtelektroden NE unterschiedlichen Materials homogen verteilt sind, oder aber es lassen sich Verteilungsstrukturen der unterschiedlichen Ionensorten einstellen, wenn die Drahtelektroden NE aus dem jeweiligen Material entsprechend verteilt sind.

Anspruch 2 kennzeichnet die hinlänglich bekannte Pierce-Elektrode, die eine laterale Beschleunigung der Ladungsträger am Rand des Beschleunigungsbereichs zwischen dem Anodengitter AG und den Kathodengitter CG1 unterdrückt.

Das erstes Kathodengitter CG1 am Ende des Beschleunigungsraums ist zur optimalen Strahlführung ebenfalls am Rand mit einer Fokussierelektrode CFE versehen (Anspruch 3).

Ein weiteres, in Strahlrichtung folgendes Kathodengitter CG2 besteht aus einem Material mit hohem Emissionskoeffizient für Sekundärelektronen (Anspruch 4).

Alle Durchführungen zu den verschiedenen Elektroden und der Stromkollektorschiene sind hochspannungsfest, so daß die angelegten Potentiale in Höhe und Vorzeichen beliebig variiert werden können (Anspruch 5).

Anspruch 6 kennzeichnet die Verschließung der Löcher im Anoden-Entladungsgitter DE und die gleichzeitige Führung der jeweiligen Drahtelektrode NE darin mit einem dielektrischen Material, das einen hohen Wasserstoffgehalt hat, so daß je nach angelegten Potentialen ein Protonen- oder Elektronenstrahl erzeugt wird.

Die Strahlenquelle hat die folgenden Vorteile:

- Verwendung von nur einer Spannungsquelle für die Produktion des die Ionen bzw. Elektronen emittierenden Plasmas und für deren Beschleunigung. Dies führt zu automatischer Synchronisation von Plasmaaufbau und Erscheinen der Beschleunigungsspannung. Hier liegt einer der besonderen Vorteile der Erfindung gegenüber anderen z. Zt. existierenden Ionenquellen, die, wie oben anhand der Brown-Quelle beschrieben, spezielle Vorrichtungen zur Plasma-Initiierung und - Aufrechterhaltung und zur Synchronisation der verschiedenen Prozesse benötigen.
- Großer Strahlquerschnitt bis zu Quadratmetern.
- Strahlhomogenität über den Strahlquerschnitt leicht optimierbar durch entsprechende Anzahl Plasmaquellen pro Fläche und ihrer Serienwiderstände $R_o$.

- Einfache Steuerbarkeit der Ionen- bzw. Elektronenstromdichte.

- Hoher Wirkungsgrad der Raumladungsneutralisation des Ionenstrahls im Driftraum führt zu geringer Strahlauffächerung.
- Unabhängigkeit des Innenwiderstandes der Quelle von der angelegten Spannung erleichtert die leistungsmäßige Anpassung der Quelle an die externe Energieversorgung.
- Erzeugt werden können sowohl Strahlen von Wasserstoff-, Kohlenstoff-, und unterschiedlichsten Metallionen, als auch Elektronenstrahlen. Des weiteren besteht die Möglichkeit, die genannten Ionen in einem Strahl zu kombinieren.

Die Erfindung wird anhand einer schematischen Darstellung im folgenden weiter erläutert. Es zeigen

Figur 1 die Ionen/Elektronen-Quelle und

Figur 2 die Anoden-Entladungselektrode bei Wasserstoffionen- oder Elektronenproduktion.

Die Quelle zur Erzeugung von großflächigen, gepulsten Ionen- und Elektronenstrahlen besteht aus:

- Der Vakuumkammer VC mit 4 Hochspannungsdurchführungen F1, F2, F3 und F4.
- Der Anoden-Entladungselektrode DE mit einem Raster von Löchern, welche einen Radius $r_1$ und einen gegenseitigen Mittenabstand voneinander haben.

Im Zentrum jedes Loches ist die zugehörige Drahtelektrode NE installiert, deren Material entsprechend der zu produzierenden Ionensorte ausgewählt wird. Jede dieser Drahtelektroden ist über einen Serienwiderstand $R_o$ mit dem Stromkollektor K verbunden. Die mit Bohrungen für die Durchführung der Drahtelektroden versehene dielektrische Platte P trennt den Raum zwischen den Drahtelektroden und den Serienwiderständen.

Im Abstand D von der Anoden-Entladungselektrode DE ist das Anodengitter AG installiert, welches an seiner Peripherie elektrisch leitend in die Anoden-Fokussierelektrode (AFE) ausläuft. Das Anodengitter AG ist mit der Anoden-Entladungselektrode DE über den Widerstand $R_{AG}$ verbunden. Der Anoden-Entladungselektrode DE wird über die Hochspannungsdurchführung F1 der Hochspannungspuls des Pulsspannungsgenerators (PVG) zugeführt.

Die Parallelschaltung aus dem Widerstand Ra und dem Kondensator $C_a$ liegt außerhalb der Vakuumkammer. Diese RC-Kombination ist einerseits über die Hochspannungsdurchführung F2 mit der Stromkollektorschiene und andererseits mit der Vakuumkammer verbunden.

Das erste Kathodengitter CG1 liegt über die Hochspannungsdurchführung F3 an einer negativen Gittervorspannung. An seiner Peripherie besitzt das erste Kathodengitter CG1 die Kathoden-Fokussierelektrode (CFE). Die Form sowohl der Kathoden als auch der bereits erwähnten Anoden-Fokussierelektrode wird so gewählt, daß eine optimale Strahlführung erreicht wird.

Das zweite Kathodengitter (CG2) ist aus einem Material gefertigt, das einen hohen Emissionskoeffizienten für Sekundärelektronen besitzt (z. B. Nickel). Dieses zweite Gitter wird über die Hochspannungsdurchführung F4 geerdet, oder es wird eine negative Gittervorspannung angelegt. Das hängt von den Erfordernissen des jeweiligen Systems ab.

Soll die Quelle benutzt werden, um einen Wasserstoffionen- oder Elektronenstrahl zu produzieren, so werden die Löcher in der Anoden-Entladungselektrode mit axial durchbohrten, dielektrischen Stopfen versehen (siehe Fig. 2), die aus einem Material mit hohem Wasserstoffgehalt gefertigt sind (z. B. Polyäthylen). Die Stopfen haben 2 abgestufte Radien ($r_1 < r_2$), deren kleinerer dem Radius der Löcher in der Anoden-Entladungselektrode entspricht. Die Stopfen werden so eingesetzt, daß der Teil mit dem größeren Radius zu den Serienwiderständen $R_o$ hin zeigt.

Mit Hilfe der Figuren 1 und 2, wobei die Figur 1 zunächst den schematischen Gesamtaufbau und Figur 2 die Anodenentladungselektrode bei Wasserstoff- und Elektroneneproduktion zeigt, wird die Funktionsweise im folgenden näher erläutert:

Ein von dem Pulsspannungsgenerator gelieferter, positiver Hochspannungspuls wird der Anoden-Entladungselektrode zugeführt. Das Auftreten der Hochspannung an der Entladungselektrode führt zur Ausbildung von elektrischen Entladungen zwischen der Elektrode selbst und den in den Löchern installierten Drahtelektroden. Der besondere Zweck der Serienwiderstände $R_o$ in den Zuleitungen der Drahtelektroden liegt darin, auch dann noch einen zum Zünden weiterer Entladungsstrecken ausreichenden Spannungsunterschied zwischen der Entladungselektrode und den Drahtelektroden aufrechtzuerhalten, wenn schon eine signifikante Anzahl von Entladungen gezündet hat. Die Einfügung und richtige Dimensionierung dieser Widerstände garantiert somit ein gleichmäßiges Zündverhalten auch für großflächige Anoden.

Für eine korrekte Funktion der Quelle müssen folgende Bedingungen erfüllt sein:
Der Radius $r_1$ der Löcher in der Anoden-Entladungselektrode DE muß die Bedingung

$$U/[r_1 \ln(r_1/r_{NE})] \geq E_b$$

erfüllen. Hierbei sind U die angelegte Anodenspannung, $r_{NE}$ der Radius der Drahtelektrode NE und $E_b$ die für die Ausbildung der Bogenentladung erforderliche Feldstärke. Der Radius $r_2$ der dielektrischen Stopfen muß die Bedingung

$$U/[r_2 \ln(r_2/r_{NE})] < E_b$$

erfüllen. In einem Ausführungsbeispiel wurde $r_2$ etwa 30% größer gewählt als $r_1$.

Die Entladung zwischen der Anoden-Entladungselektrode DE und den Drahtelektroden NE führt zur Ausbildung eines Plasmas, welches als Emitter von Ionen und Elektronen fungiert und in den Raum zwischen der Anoden-Entladungselektrode und dem Anodengitter hinein expandiert. Um eine homogene Dichte des Plasmas im Bereich des Anodengitters AG zu erreichen, muß der Abstand $\triangle$ zwischen den einzelnen Drahtelektroden NE kleiner sein als der Abstand D zwischen Anoden-Entladungselektrode DE und Anodengitter AG, also

$$\triangle < D.$$

Hat das Plasma die Löcher im Anodengitter erreicht, so gerät es unter den Einfluß des bereits seit dem Anlegen des Hochspannungspulses bestehenden elektrischen Feldes. Die Feldkräfte extrahieren die geladenen Teilchen (je nach Betriebsart Ionen oder Elektronen) aus dem Plasma und beschleunigen diese in Richtung auf die Kathodengitter CG1 und CG2. Die erzielte Teilchenstromdichte wird durch die Dichte des Anodenplasmas bestimmt.

Experimente haben gezeigt, daß bei der hier präsentierten Quelle die Plasmadichte proportional dem gesamten Entladungsstrom also der Summe aller die Drahtelektroden abfließenden Ströme ist. Der Proportionalitätskoeffizient wird experimentell bestimmt. Er liegt erfahrungsgemäß bei etwa 0.05.

Ein anderer experimenteller Befund ist die Erhöhung der Strahlstroms um 50 % bei Verwendung des Widerstandes $R_{AG}$ zwischen dem Anodengitter AG und der Anoden-Entladungselektrode DE. Der Widerstandswert von $R_{AG}$ muß der schon oben aufgeführten Bedingung

$$R_{AG} \gg T_e / e \, I_{iO} \, (1-\alpha)$$

genügen, da nur in diesem Fall das Anodengitter AG das "floating potential" des Anodenplasmas annimmt.

Beim Durchgang des Ionenstrahls durch die Kathodengitter trifft ein Teil der Ionen auf die Gitter auf, aus denen sie durch Sekundäremission Elektronen auslösen, die wiederum benötigt werden, um in dem hinter den Kathodengittern liegenden Driftraum die Raumladung des Ionenstrahls zu kompensieren. Liegen beide Kathodengitter CG1 und CG2 auf negativem Potential und erfüllt die Spannungsdifferenz zwischen ihnen die Bedingung

$$|U_{g1}-U_{g2}| \geq j_i l^2/(v_i)^2 \in_0,$$

so bewegt sich der Hauptteil der ausgelösten Sekundärelektronen nicht in Richtung Anode sondern mit dem Ionenstrahl, wodurch ein hoher Raumladungs-Neutralisierungsgrad erreicht wird und keine zusätzliche Last für den Pulsspannungsgenerator PVG entsteht. Hierbei ist $j_i$ die Ionenstromdichte, I der Abstand zwischen den beiden Kathodengittern, $v_i$ die der angelegten Anodenspannung entsprechende Ionengeschwindigkeit und $\in_o$ die Vakuum-Dielektrizitätkonstante. Ein typischer Wert für die Spannung des ersten Kathodengitters CG1 ist -1 kV.

Der hohe Raumladungs-Neutralisierungsgrad hat zur Folge, daß der Strahl z. B. zwecks Erreichung höherer Stromdichte ballistisch fokussiert werden kann.

Eine weitere günstige Auswirkung der zwischen den Kathodengittern liegenden Spannung liegt darin, daß die Inhomogenität des elektrischen Feldes nahe der Oberfläche des 1. Kathodengitters gesenkt und dadurch die Strahldiverenz reduziert werden kann.

Produktion unterschiedlicher Ionensorten:
Da die in den Löchern der Anoden-Entladungselektrode DE installierten Drahtelektroden für die Bogenentladungen die Kathoden darstellen, enthält das hierbei entstehende Plasma im wesentlichen Ionen des Drahtlektrodenmaterials. Somit kann durch einfaches Austauschen der Drahtelektroden die mit der Quelle produzierte Ionensorte geändert werden.

Für die Produktion eines Strahls von Kohlenstoffionen werden die Drahtelektroden durch Bündel von Kohlenstoffasern ersetzt.

Produktion eines Strahls von mehreren, unterschiedlichen Ionen:
Bei der Produktion eines Strahls von mehreren, unterschiedlichen Ionen wird die Anzahl der Drahtelektroden eines bestimmten Materials, bzw. die Anzahl der Kohlestofffaserbündel, bzw. die Anzahl der dielektrischen Stopfen entsprechend der gewünschten Stahlzusammensetzung gewählt.

Die Produktion eines Elektronen- anstatt eines Ionenstrahls erfordert keinerlei mechanische Änderungen, sondern lediglich zwei Änderungen in den elektrischen Verbindungen:

- Die Polarität des Pulsspannungsgenerators PVG wird invertiert, so daß der Anode nunmehr ein negativer Spannungspuls zugeführt wird.
- Beide Kathodengitter werden dann elektrisch mit der Vakuumkammer VC der Quelle verbunden.

Bezugszeichenliste

AFE     Anodenfokussierelektrode
AG     Anodengitter
$C_A$     Kondensator
CG1     Kathodengitter
CG2     Kathodengitter
CFE     Kathodenfokussierelektrode
DE     Anoden-Entladungselektrode
$F_{1234}$     Hochspannungsdurchführungen
K     Stromkollektorschiene
P     dielektrische Platte
PVG     Pulsspannungsgenerator, Netzgerät
$R_A$     Außenwiderstand
$R_{AG}$     Widerstand
$R_0$     Serienwiderstand, Widerstand
$U_{g12}$     Spannung am Kathodengitter
VC     Vakuumkammer

**Patentansprüche**

1. Quelle zur Erzeugung von großflächigen, gepulsten Ionen- und Elektronenstrahlen, bestehend aus einer in einem Vakuumgefäß untergebrachten Vakuum-Bogenplasmaquelle mit Expansionsraum und einem Extraktionssystem, wobei die Bogenplasmaquelle aus einer geordneten Anordnung von Drahtelektroden NE besteht, deren Drähte zwecks sicheren Zündverhaltens jeweils über einen ohmschen Widerstand $R_0$ an einer Stromkollektorschiene K angeschlossen sind und die mit ihren freien Enden in einem Raster von Löchern in einer Anoden-Entladungselektrode DE jeweils zentral enden, dadurch gekennzeichnet, daß

ein Anodengitter AG über einen Widerstand $R_{AG}$ mit der Anoden-Entladungselektrode DE verbunden ist, wodurch unter Berücksichtigung der Schranke

$$R_{AG} \gg T_e \,/\, e\, I_{iO}\, (1\text{-}\alpha),$$

das Anodengitter AG das "floating potential" des Anodenplasmas annimmt,
die Stromkollektorschiene K über eine Parallelschaltung aus einem Kondensator $C_a$ zur sicheren Zündung der Bogenentladungen zwischen den Drahtelektroden NE und der Anoden-Entladungselektrode DE und einem Widerstand $R_a$ zur Steuerung der Größe des Ionenstroms mit der Wand des Vakuumgefäßes verbunden ist,
die Dimensionierung der elektrischen Baukomponenten $R_O$, $R_A$, $C_A$ folgende Einschränkung berücksichtigt

$$T/[(R_A + R_{||})/R_A R_{||}] \gg C_A \gg \tau/[(R_A + R_{||})/R_A R_{||}],$$

mit

$$R_{||} = R_o/n$$

und zwischem dem Lochabstand $\triangle$ und dem Abstand D zwischen der Anoden-Entladungselektrode DE und dem Anodengitter AG die Bedingung

$$\triangle \; < \; D$$

eingehalten ist,
eine mit Bohrungen für die Durchführung der Drahtelektroden NE versehene Platte P den Raum zwischen den Drahtelektroden NE und den Serienwiderständen $R_0$ voneinander abschottet, die Drahtelektroden NE zur Erzeugung einer Ionensorte aus ein und demselben oder zur Erzeugung eines in seinem Querschnitt bezüglich der auftretenden Ionensorten homogenen oder strukturierten Ionenstromes aus entsprechend unterschiedlichem Material und entsprechender Anordnung der Drahtelektroden NE besteht.

2. Quelle zur Erzeugung von großflächigen, gepulsten Ionen- und Elektronenstrahlen nach Anspruch 1, dadurch gekennzeichnet, daß
im vorgegebenen Abstand von der Anoden-Entladungselektrode DE ein Anodengitter AG installiert ist, welches an seiner Peripherie elektrisch leitend in eine Anoden-Fokussierelektrode AFE (Pierce-Elektrode) ausläuft.

3. Quelle zur Erzeugung von großflächigen, gepulsten Ionen- und Elektronenstrahlen nach Anspruch 2, dadurch gekennzeichnet, daß
in einem vorgegebenen Abstand zum Anodengitter AG ein erstes Kathodengitter CG1 installiert ist, an dessen Peripherie sich zur optimalen Strahlführung eine Kathoden-Fokussierelektrode CFE (Pierce-Elektrode) befindet.

4.   Quelle zur Erzeugung von großflächigen, gepulsten Ionen- und Elektronenstrahlen nach Anspruch 3, dadurch gekennzeichnet, daß
ein zweites, in Strahlrichtung folgendes Kathodengitter CG2 aus einem Material gefertigt ist, das einen hohen Emissionskoeffizienten für Sekundärelektronen besitzt.

5.   Quelle zur Erzeugung von großflächigen, gepulsten Ionen- und Elektronenstrahlen nach Anspruch 4, dadurch gekennzeichnet, daß
die Spannungsversorgungen für die Elektroden DE, CG1 und CG2 über Hochspannungsdurchführungen $F_1$, $F_3$ und $F_4$ erfolgt und die Stromkollektorschiene K über eine Hochspannungsdurchführung $F_2$ mit der Parallelschaltung aus dem Kondensator $C_A$ und dem Widerstand $R_A$ verbunden ist.

6.   Quelle zur Erzeugung von großflächigen, gepulsten Ionen- und Elektronenstrahlen nach Anspruch 5, dadurch gekennzeichnet, daß
zur Erzeugung eines Wasserstoffionen- oder eines Elektronenstrahls die Löcher in der Anoden-Entladungselektrode DE mit axial durchbohrten, dielektrischen Stopfen oder Pfropfen verstopft sind, die aus einem Material mit hohem Wasserstoffgehalt bestehen und mit denen die jeweilige Drahtelektrode NE axial geführt wird.

## Fig. 1

zu behandelnde Oberfläche

## Fig. 2